# EUROPEAN PATENT APPLICATION

(11) **EP 4 614 563 A1**
(43) Date of publication of application: **10.09.2025**
(21) Application number: 23890608.5
(22) Date of filing: 01.11.2023
(51) Int. Cl.: H01L 23/40, H01L 23/367, H01L 23/31, H01L 25/16, H01L 23/48

(54) **POWER MODULE ASSEMBLY AND ELECTRONIC DEVICE COMPRISING SAME**

(30) Priority: 17.11.2022 CN 202211442177; 17.11.2022 CN 202211457344; 31.08.2023 CN 202311117772
(71) Applicant: Hisense Home Appliances Group Co., Ltd., Foshan, Guangdong 528303 (CN)
(72) Inventor: XIE, Dilin, Foshan, Guangdong 528303 (CN); ZHOU, Wenjie, Foshan, Guangdong 528303 (CN); LI, Zhengkai, Foshan, Guangdong 528303 (CN); LIU, Jian, Foshan, Guangdong 528303 (CN); CHENG, Zhangming, Foshan, Guangdong 528303 (CN); BIE, Qingfeng, Foshan, Guangdong 528303 (CN)
(74) Representative: Casalonga
(86) International application number: PCT/CN2023/129116
(87) International publication number: WO 2024/104172

(57) **Abstract**

Provided are a power module assembly and an electronic device comprising same. The power module assembly comprises a plastic package body, a first substrate provided in the plastic package body, a power chip provided on the first substrate, and at least one pad. The plastic package body has a first surface and a second surface opposite to each other, and comprises at least one connection portion located at an end portion of the plastic package body. The at least one pad is provided on the first surface of the plastic package body and corresponds to the at least one connection portion, and the orthographic projection of the pad on the first surface does not overlap the orthographic projection of the first substrate on the first surface. The plastic package body is configured to be connected to a heat exchanger by means of the pad and the connection portion, so that the second surface of the plastic package body is in contact with the heat exchanger.

## Description

### CROSS-REFERENCE TO RELATED APPLICATIONS

This application claims priorities to Chinese Patent Application No.202211442177.8, filed on November 17, 2022, Chinese Patent Application No.202211457344.6, filed on November 17, 2022, and Chinese Patent Application 202311117772.9, filed on August 31, 2023, which are incorporated herein by reference in their entireties.

### TECHNICAL FIELD

The present disclosure relates to the technical field of electronic device, and in particular, to a power module assembly and an electronic device comprising the same.

### BACKGROUND

Semiconductor power modules generate heat during use. In order to ensure a good heat dissipation effect, it usually needs to be mounted on a heat exchanger and use air as the medium for heat dissipation.

### SUMMARY

On the one hand, a power module assembly is provided, the power module assembly includes a plastic package body, a first substrate disposed in the plastic package body, a power chip disposed on the first substrate, and at least one pad. The plastic package body has a first surface and a second surface that are opposite to each other, and includes at least one connection portion located at an end of the plastic package body. The at least one pad is disposed on the first surface of the plastic package body and corresponds to the at least one connection portion, and an orthographic projection of the pad on the first surface does not overlap with an orthographic projection of the first substrate on the first surface. The plastic package body is configured to be connected with a heat exchanger through the pad and the connection portion, so that the second surface of the plastic package body is in contact with the heat exchanger.

On the other hand, an electronic device is provided, the electronic device includes a controller and the above-mentioned power module assembly, the power module assembly is connected with the controller.

### BRIEF DESCRIPTION OF THE DRAWINIGS

FIG. 1 is a schematic diagram of a position relationship between a first substrate and a pad of a power module assembly in the related art;
FIG. 2 is an encapsulation effect diagram of a power module assembly in the related art;
FIG. 3 is a schematic diagram of a power module assembly, in accordance with some embodiments of the present disclosure;
FIG. 4 is another schematic diagram of the power module assembly, in accordance with some embodiments of the present disclosure;
FIG. 5 is a schematic diagram of a position relationship between a first substrate and a pad, in accordance with some embodiments of the present disclosure;
FIG. 6 is another schematic diagram of the position relationship between the first substrate and the pad, in accordance with some embodiments of the present disclosure;
FIG. 7 is an encapsulation effect diagram of the power module assembly, in accordance with some embodiments of the present disclosure;
FIG. 8 is a sectional view of the power module assembly, in accordance with some embodiments of the present disclosure;
FIG. 9 is another encapsulation effect diagram of the power module assembly, in accordance with some embodiments of the present disclosure;
FIG. 10 is another sectional view of the power module assembly, in accordance with some embodiments of the present disclosure;
FIG. 11 is another schematic diagram of the power module assembly, in accordance with some embodiments of the present disclosure;
FIG. 12 is yet another schematic diagram of the power module assembly, in accordance with some embodiments of the present disclosure;
FIG. 13 is a sectional view of a power module, in accordance with some embodiments of the present disclosure;
FIG. 14 is an encapsulation effect diagram of the power module, in accordance with some embodiments of the present disclosure;
FIG. 15 is another sectional view of the power module, in accordance with some embodiments of the present disclosure;
FIG. 16 is a schematic diagram of an encapsulation mold of the power module, in accordance with some embodiments of the present disclosure;
FIG. 17 is yet another sectional view of the power module, in accordance with some embodiments of the present disclosure;
FIG. 18 is a plan view of the power module, in accordance with some embodiments of the present disclosure; and
FIG. 19 is a block diagram of an electronic device, in accordance with some embodiments of the present disclosure.

### DETAILED DESCRIPTION

Some embodiments of the present disclosure will be described clearly and completely with reference to the accompanying drawings; however, the described embodiments are merely some but not all embodiments of the present disclosure. All other embodiments obtained by a person of ordinary skill in the art based on embodiments of the present disclosure should belong to the protection scope of the present disclosure.

Unless the context requires otherwise, throughout the description and the claims, the term "comprise" and other forms thereof such as the third-person singular form "comprises" and the present participle form "comprising" are construed as open and inclusive meaning, i.e., "included, but not limited to." " **In** the description of the specification, terms such as "one embodiment", "some embodiments", "exemplary embodiments," "example," "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). **In** addition, the specific features, structures, materials, or characteristics described may be included in any one or more embodiments or examples in any suitable manner.

Hereinafter, terms such as "first" and "second" are used for descriptive purposes only, and are not to be construed as indicating or implying the relative importance or implicitly indicating the number of indicated technical features. Thus, a feature defined with "first" or "second" may explicitly or implicitly include one or more of the features. In the description of the embodiments of the present disclosure, the terms "a plurality of", "the plurality of" and "multiple" each mean two or more unless otherwise specified.

Some embodiments may be described using the term "connected" and its derivatives. For example, the term "connected" may be used in the description of some embodiments to indicate that two or more components are in direct physical or electrical contact with each other. The embodiments disclosed herein are not necessarily limited to the content herein.

The phrase "A and/or B" includes the following three combinations:only A, only B, and a combination of A and B.

The term such as "about", "substantially" or "approximately" as used herein includes a stated value and an average value within an acceptable range of deviation of a particular value, and the acceptable range of deviation is determined by a person of ordinary skill in the art, considering measurement in question and errors (i.e., limitations of a measurement system) associated with measurement of a particular quantity.

Exemplary embodiments are described herein with reference to sectional views and/or plan views as idealized exemplary accompanying drawings. In the accompanying drawings, thicknesses of layers and sizes of regions are enlarged for clarity. Exemplary embodiments of the present disclosure should not be construed to be limited to shapes of regions shown herein, but to include deviations in shape due to, for example, manufacturing. For example, an etched area/region shown in a rectangular shape generally has a feature of being curved. Therefore, the regions shown in the accompanying drawings are schematic in nature, and their shapes are not intended to show actual shapes of regions in the apparatuses, and are not intended to limit the scope of the exemplary embodiments.

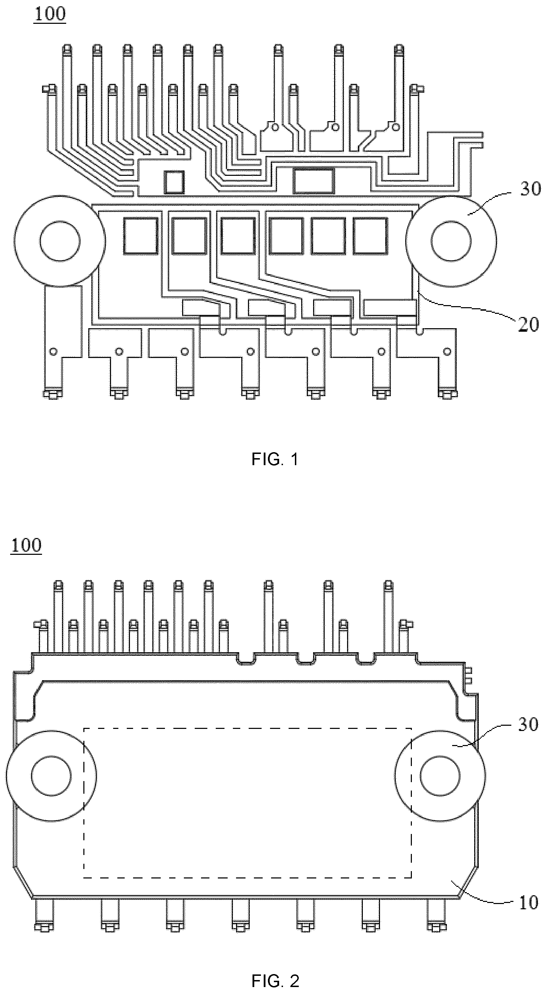

Semiconductor power modules will inevitably generate heat during use. In order to ensure a good heat dissipation effect, the heat dissipation area of the power module needs to be increased. Therefore, when designing the power module, the size of the first substrate (insulating heat dissipation substrate) is increased as much as possible. In the related art, as shown in FIG. 1 and FIG. 2, the power module 100 may be mounted on a heat exchanger through the screws for heat dissipation, which requires reserving the mounting positions of the screws on the plastic package body 10 of the power module 100, however, this might limit the size of the first substrate 20. In addition, when the plastic package body 10 is fixedly connected to the heat exchanger, the heat exchanger will squeeze the plastic package body 10, and the squeezing force will be transmitted to the first substrate 20 through the plastic package body 10, which may easily cause damage to the first substrate 20. Therefore, the screws usually need to be used in conjunction with pads 30 to disperse the pre-tightening force of the screws and to provide a buffer to a certain extent for the squeezing action of the heat exchanger. However, this will also cause the axial force of the pad 30 to act on the edge of the first substrate 20 through the plastic package body 10 at the same time, thus the risk of the first substrate 20 being crushed is increased, causing a relatively low structural reliability of the power module.

Based on this, embodiments of the present disclosure provides a power module assembly, the power module assembly includes a power module and at least one pad, which can be applied to an electronic device. The power module may be an intelligent power module (IPM).

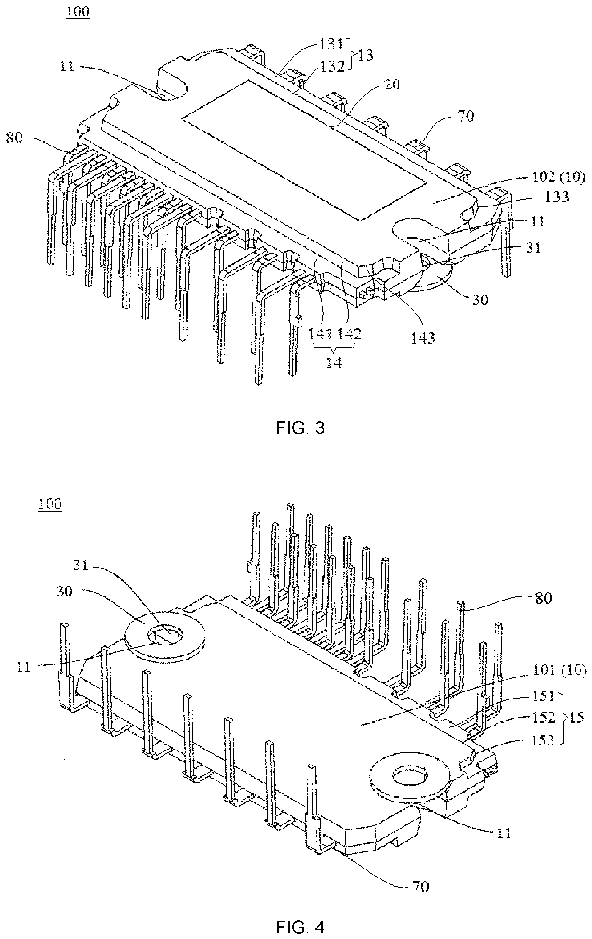

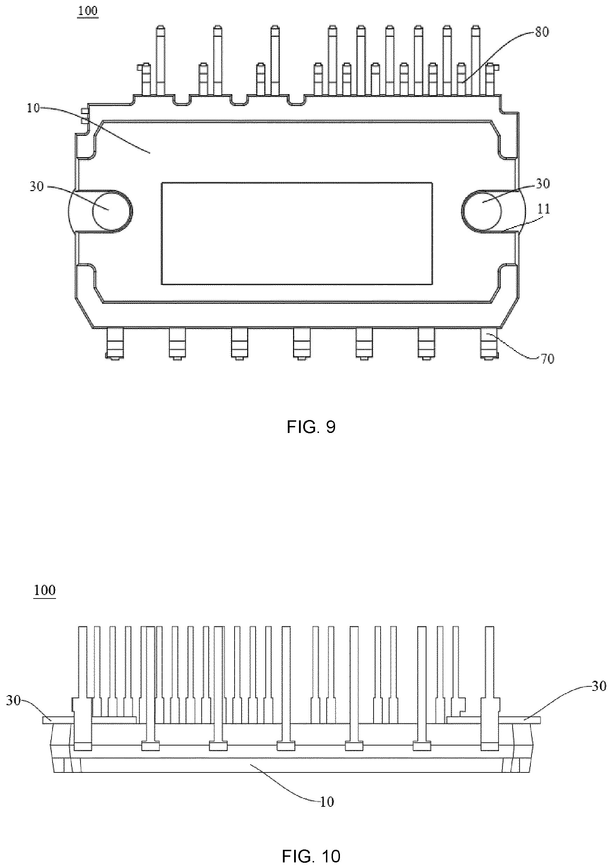

As shown in FIGS. 3 to 12, the power module 100 may include a plastic package body 10, a first substrate 20 disposed in the plastic package body 10, and a power chip 40 disposed on the first substrate 20.

The plastic package body 10 has a first surface 101 and a second surface 102 that are opposite to each other along a thickness direction Z of the power module 100 (i.e., a thickness direction of the plastic package body 10). The first surface 101 is located on a side of the power chip 40 away from the first substrate 20, and the second surface 102 is located on a side of the first substrate 20 away from the power chip 40. The plastic package body 10 may include at least one connection portion 11 located at an end of the plastic package body 10, and the connection portion 11 is configured to be connected to the heat exchanger. For example, the connection portion 11 is disposed at an end of the plastic package body 10 along a length direction X of the power module 100 (i.e, a length direction of the plastic package body 10).

The first substrate 20 may be an insulating heat dissipation substrate. For example, a surface (front side) of the first substrate 20 close to the first surface 101 is used as a power pad, on which the power chip 40 is provided. A surface (back side) of the first substrate 20 close to the second surface 102 is flush with the second surface 102, so that the first substrate 20 is exposed by the second surface 102 of the plastic package body 10, so as to provide a heat dissipation path for the power chip 40.

At least one pad 30 may be disposed on the first surface 101 of the plastic package body 10, and the at least one pad 30 corresponds to the at least one connection portion 11. An orthographic projection of the pad 30 on the first surface 101 of the plastic package body 10 does not overlap with an orthographic projection of the first substrate 20 on the first surface 101 of the plastic package body 10 (i.e, the two being staggered with each other).

It can be understood that the at least one pad 30 corresponds to the at least one connection portion 11 refers to the positions of the pad 30 and the connection portion 11 correspond to each other along the thickness direction Z of the power module 100.

It will be noted that, the length direction X, the width direction Y and the thickness direction Z of the power module 100 were referred to when describing the structure of the power module 100. The thickness direction Z of the power module 100 (i.e., the thickness direction of the plastic package body 10) refers to a direction perpendicular to a plane where the first substrate 20 is located, the length direction X (i.e., the length direction of the plastic package body 10) and the width direction Y (i.e., the width direction of the plastic package body 10) of the power module 100 are both directions parallel to the plane where the first substrate 20 is located, and the length direction X of the power module 100 refers to an arrangement direction of a plurality of base islands for arranging a plurality of power chips 40, and the width direction Y of the power module 100 refers to the extending direction of any of the plurality of base islands.

In order to obtain a good heat dissipation effect, the plastic package body 10 of the power module 100 may be connected to a heat exchanger. When the plastic package body 10 is connected to the heat exchanger, the screws may pass through the pad 30 and the connection portion 11 of the plastic package body 10 in sequence, so that the plastic package body 10 is connected to the heat exchanger, and the second surface 102 of the plastic package body 10 is in contact with the heat exchanger. In this way, the heat exchanger may absorb the heat generated by the power chip 40 in the plastic package body 10 through the first substrate 20 exposed by the second surface 102 of the plastic package body 10, and exchange heat with the external air to realize the effect of dissipating the heat of the plastic package body 10 and the power chip 40 in it, so as to ensure that the power module 100 operates stably and efficiently.

Based on this, in the embodiments of the present disclosure, the pad 30 may be a standard pad, and there is no need to customize a special pad. The standard pad refers to a pad with standard specifications specified in ISO-7089~ISO-7093, and there are two types of applicable pad specifications here: one is a pad with an inner diameter of 3.2mm and an outer diameter of 7mm, and another is an enlarged pad with an inner diameter of 3.2mm and an outer diameter of 9mm. Generally, the installation solution may adopt a pad with an inner diameter of 3.2mm and an outer diameter of 7mm. Without changing the size of the pad 30, the thickness and material of the plastic package body 10, and the structure and weight of the heat exchanger, the size of the first substrate 20 may be controlled, so that the orthographic projection of the pad 30 on the first surface 101 of the plastic package body 10 and the orthographic projection of the first substrate 20 on the first surface 101 of the plastic package body 10 can be staggered with each other, so as to realize a balance between the heat dissipation performance and the mechanical properties of the power module 100. Since the contact between the second surface 102 of the plastic package body 10 and the heat exchanger may make the power module 100 have a good heat dissipation effect, so that the first substrate 20 and the pad 30 are staggered in the thickness direction Z of the power module 100 by means of reducing the size of the first substrate 20 will not cause the deterioration of the heat dissipation performance of the power module 100. That is, the embodiment of the present disclosure reduces the size of the first substrate 20 while ensuring the heat dissipation performance of the power module 100, so that the orthographic projection of the pad 30 on the first surface 101 of the plastic package body 10 does not overlap with the orthographic projection of the first substrate 20 on the first surface 101 of the plastic package body 10.

In this way, the squeezing action of the heat exchanger may be buffered to a certain extent by providing the pad 30 at a position of the plastic package body 10 corresponding to the connection portion 11, so as to improve the structural reliability of the power module 100. The orthographic projection of the pad 30 on the first surface 101 of the plastic package body 10 is staggered with the orthographic projection of the first substrate 20 on the first surface 101 of the plastic package body 10, so that the force transmitted to the pad 30 may be avoided from acting directly and perpendicularly on the first substrate 20. Instead, the force needs to be transmitted to the plastic package body 10 and evenly distributed on the plastic package body 10 before being transmitted to the first substrate 20. As a result, the force applied to the first substrate 20 may be significantly reduced, which is coducive to realizing the balance between the heat dissipation performance and the mechanical properties of the power module 100, not only the service life of the first substrate 20, the structural stability and reliability of the power module 100 may be improved, but also significantly changes of the structural design of the power module 100 can be avoided, thereby reducing production costs.

In some embodiments, the orthographic projection of the pad 30 on the first surface 101 of the plastic package body 10 and the orthographic projection of the first substrate 20 on the first surface 101 of the plastic package body 10 are disposed at intervals. That is, there is a certain distance between the orthographic projection of the pad 30 on the first surface 101 and the orthographic projection of the first substrate 20 on the first surface 101.

In this case, when the squeezing force of the heat exchanger is transmitted to the pad 30 and then transmitted to the plastic package body 10 through the pad 30, since there is a certain distance between the orthographic projection of the pad 30 on the first surface 101 and the orthographic projection of the first substrate 20 on the first surface 101, the force needs to be further dispersed on the plastic package body 10 before it acts on the first substrate 20. That is, the plastic package body 10 buffers and absorbs the force to a certain extent. In this way, the force transmitted from the pad 30 to the first substrate 20 may be effectively reduced, so as to improve the stability and reliability of the first substrate 20.

In some other embodiments, an edge of the orthographic projection of the pad 30 on the first surface 101 of the plastic package body 10 contacts with but does not overlap with an edge of the orthographic projection of the first substrate 20 on the first surface 101 of the plastic package body 10. That is, the edge of the orthographic projection of the pad 30 on the first surface 101 is tangent to the edge of the orthographic projection of the first substrate 20 on the first surface 101.

In this case, since a distance between the orthographic projection of the pad 30 on the first surface 101 and the orthographic projection of the first substrate 20 on the first surface 101 is small, the size of the power module 100 along its length direction X is reduced, which makes the structure of the power module 100 more compact, so as to realize the miniaturization design of the power module 100.

Whether the orthographic projection of the pad 30 on the first surface 101 of the plastic package body 10 is in contact with or spaced apart from the orthographic projection of the first substrate 20 on the first surface 101 of the plastic package body 10 may be designed according to actual needs.

In some embodiments, as shown in FIGS. 3 to 12, the at least one connection portion 11 may include two connection portions 11 located at two ends of the plastic package body 10 along the length direction X of the power module 100, and the two connection portions 11 are arranged symmetrically. Correspondingly, the at least one pad 30 may include two pads 30 corresponding to the two connection portions 11 respectively.

In this way, when the plastic package body 10 is fixed on the heat exchanger by means of screws and the pads 30, since the two connection portions 11 are symmetrically arranged at the two ends of the plastic package body 10, the two pads 30 are also symmetrically arranged at the two ends of the plastic package body 10, so as to ensure the force balance at the two ends of the plastic package body 10.

In some embodiments, as shown in FIGS. 3 to 12 , the connection portion 11 may be a notch, for example, a notch with a closed shape (such as a circular notch) or a notch with a semi-closed shape (such as a U-shaped notch). Along the thickness direction Z of the power module 100, the center of the pad 30 is directly opposite to the center of the notch.

For example, the connection portion 11 is a U-shaped notch. In the length direction X of the power module 100, an opening of the U-shaped notch is away from the center of the power module 100. In the thickness direction Z of the power module 100, the U-shaped notch is a through hole that passes through from top to bottom. The pad 30 has a through hole 31 at its center, and the center of the through hole 31 coincides with the orthographic projection of the center of the U-shaped notch on the plane where the plastic package body 10 is located.

It can be understood that the connection portion 11 is used as a screw hole here. When connecting the heat exchanger and the plastic package body 10, a screw may be sequentially inserted through the through hole 31 of the pad 30, the screw hole on the plastic package body 10, and the screw hole on the heat exchanger, so as to realize a fixed connection between the heat exchanger and the plastic package body 10. In addition, in order to ensure the buffering effect of the pad 30 on the force from the screws, a diameter of a screw head need to be less than or equal to a diameter of the pad 30, so that the force from the screws can be dispersed to a certain extent through the pad 30 with a greater area (relative to the screw head).

Such provision may make it easier to disperse the force transmitted from the pad 30 to the plastic package body 10, and may further reduce the force acting on the first substrate 20, so as to further improve the structural reliability of the power module 100.

**In** order to ensure that the orthographic projection of the pad 30 on the first surface 101 of the plastic package body 10 does not overlap with the orthographic projection of the first substrate 20 on the first surface 101 of the plastic package body 10, the size of the first substrate 20, the positional relationship between the pad 30 and the first substrate 20 and the plastic package body 10, and the positional relationship between plurality of pads 30 may be designed.

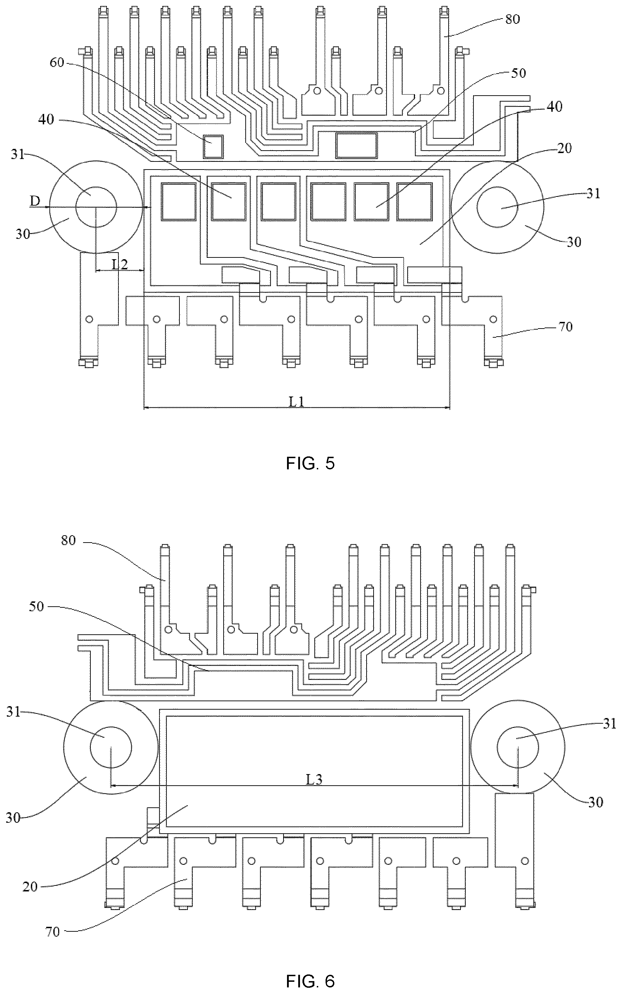

**In** some embodiments, as shown in FIG. 5, a dimension of the first substrate 20 along the length direction X of the power module is L1, and L1 is greater than 22.3mm and less than 22.9mm (i.e., L1 satisfies: 22.3mm < L1 < 22.9mm).

For example, the pads 30 is located on at least one side of the first substrate 20 along the length direction X thereof, the length of the first substrate 20 (i.e, the dimension along the length direction X of the power module 100) is L1, and L1 is greater than 22.3mm and less than 22.9mm (i.e., L1 satisfies the relationship: 22.3mm < L1 < 22.9mm). **In** a case where the length L1 of the first substrate 20 is less than 22.3 mm, there is a risk that the heat dissipation performance does not meet the requirements; in a case where the length L1 of the first substrate 20 is greater than 22.9 mm, the pad 30 may press onto the first substrate 20. Based on this, by setting the length of the first substrate 20 between 22.3 mm and 22.9 mm, for example, 22.7 mm,not only the length of the first substrate 20 being too large may be prevented, which may cause the orthographic projection of the first substrate 20 on the first surface 101 of the plastic package body 10 to overlap with the orthographic projection of the pad 30 on the first surface 101 of the plastic package body 10, thereby causing the pad 30 to directly transfer the force vertically downward to the first substrate 20, but also the length of the first substrate 20 from being too small may be prevented, which may cause the heat dissipation performance to fail to meet the requirements, thereby affecting the normal operation of the power chip 40. Furthermore, within the above range, the greater L1 is, the better the heat dissipation performance is, and the smaller L1 is, the lower the cost is.

In some embodiments, as shown in FIG. 5, a distance between a center of the pad 30 and a side of the first substrate 20 close to the pad 30 is L2, and L2 is greater than 3.45mm and less than 3.75mm (i.e., L2 satisfies: 3.45mm < L2 < 3.75mm).

For example, along the length direction X of the power module 100, the distance between the center of the pad 30 and the side of the first substrate 20 close to the pad 30 is L2, and L2 is greater than 3.45mm and less than 3.75mm (i.e., L2 satisfies the relationship: 3.45mm < L2 < 3.75mm). The selection of a lower limit of the value of L2 is determined by comprehensively considering the size of the pad 30 and the tolerances of each sizes. For example, the radius of the pad 30 is 3.5 mm, so the lower limit of the value of L2 is set to 3.45mm. An upper limit of the value of L2 is a maximum size that can be implemented by comprehensively considering other sizes (such as L1 mentioned above and L3 to be described below). Based on this, the distance between the center of the pad 30 and a side of the first substrate 20 can be set to a range of 3.45mm to 3.75mm, for example, 3.55mm, not only the distance between the two being too large may be prevented, resulting in the volume of the power module 100 being too large, thereby increasing the production cost of the power module 100 and the difficulty of installing the power module 100 on an electronic device, but also the distance between the two being too small may be prevented, resulting in the force applied to the pad 30 being directly and vertically transmitted to the first substrate 20, making the first substrate 20 prone to damage. In this way, the structural reliability of the power module 100 may be further improved. Furthermore, within the above range, the smaller L2 is, the greater the design size of L1 may be, and the heat dissipation performance can be improved; the greater L2 is, the greater the distance between the pad 30 and the first substrate 20 is, the lower the risk of the pad 30 fracturing the first substrate 20 will be.

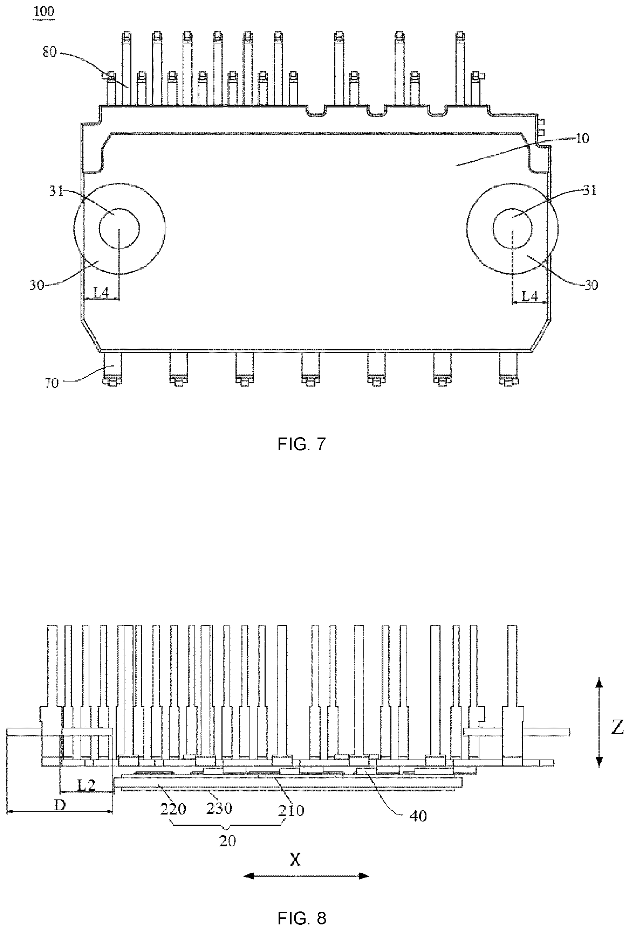

In some embodiments, as shown in FIG. 7, a distance between the center of the pad 30 and a side of the plastic package body 10 close to the pad 30 is L4, L4 is greater than 1.5mm and less than or equal to 3mm (i.e., L4 satisfies: 1.5mm < L4 ≤ 3mm).

For example, along the length direction X of the power module 100, the distance between the center of the pad 30 and the side of the plastic package body 10 close to the pad 30 is L4, L4 is greater than 1.5mm and less than or equal to 3mm (i.e., L4 satisfies the relationship: 1.5mm < L4 ≤ 3mm). The selection of the range of L4 is determined by comprehensively considering overall size, cost and actual use. An upper limit of L4 is set to 3mm to meet the requirements of cost control and size control; a lower limit of L4 is set to 1.5mm to ensure that the pad 30 with a radius of 3.5mm does not have a large area of suspension, so as to avoid reliability risks. Based on this, the distance between the center of the pad 30 and the side of the plastic package body 10 can be set to a range of 1.5mm to 3mm, not only the size of the plastic package body 10 along the length direction X of the power module 100 being too large may be prevented, resulting in the volume of the plastic package body 10 being too large. Besides, compared with the distance 1.5mm in the related art, there is a greater distance between the center of the pad 30 and the side of the plastic package body 10 close to the pad 30, which may increase the contact area between the pad 30 and the plastic package body 10, so that the force transmitted by the pad 30 to the plastic package body 10 is more stable and uniform, and the force transmitted from the pad 30 to the plastic package body 10 is prevented from being too concentrated, resulting in the force transmitted from the plastic package body 10 to the first substrate 20 being too concentrated, thereby further improving the stability and reliability of the structure of the first substrate 20. Furthermore, within the above range, the smaller L4 is, the smaller the product size is, the higher the power density is, the lower the cost is.

In some embodiments, as shown in FIG. 6, a distance between the centers of the two pads 30 is L3, and L3 is greater than 29.5mm and less than 30mm (i.e., L3 satisfies: 29.5mm < L3 < 30mm).

For example, a pad 30 is respectively provided on two ends of the plastic package body 10 along the length direction X thereof. The distance between the centers of the two pads 30 is L3, and L3 is greater than 29.5mm and less than 30mm (i.e., L3 satisfies the relationship: 29.5mm < L3 < 30mm). The selection of the range of L3 is determined based on the existing products in the market and the mounting tolerance. Based on this, the volume of the power module 100 may be ensured not to be too large while reducing the magnitude of the force transmitted from the pad 30 to the first substrate 20, thereby further improving the structural reliability of the power module 100. Furthermore, within the above range, the smaller L3 is, the smaller the product size is, the higher the power density is, the lower the cost is.

In some embodiments, as shown in FIG. 5, the pad 30 may be a circular pad. The diameter of the pad 30 is D, and D is greater than 6.8mm and less than 7mm (i.e., D satisfies: 6.8mm < D < 7mm).

For example, the pad 30 may be a standard pad, and its diameter D is greater than 6.8mm and less than 7mm (i.e., D satisfies the relationship: 6.8mm < D < 7mm). Based on this, a pad 30 with an appropriate diameter may be selected according to the process requirements for mounting different power modules 100 and heat exchangers. In this way, the pad 30 can meet the requirements of more different power modules 100 without customizing special pads, thereby improving the applicability of the pad 30.

On this basis, since L2 is greater than 3.4mm and less than 3.75mm (i.e., L2 satisfies the relationship: 3.4mm < L2 < 3.75mm), and D is greater than 6.8mm and less than 7mm (D satisfies the relationship: 6.8mm < D < 7mm), the radius of the pad 30 is less than or equal to the distance L2 between the center of the pad 30 and the side of the first substrate 20 close to the pad 30 (i.e, D/2≤L2). In this way, the difference between the distance L2 between the center of the pad 30 and the side of the first substrate 20 close to the pad 30 and the radius of the pad 30 (i.e., L2-D/2) is the distance between the orthographic projection of the pad 30 on the first surface 101 of the plastic package body 10 and the orthographic projection of the first substrate 20 on the first surface 101 of the plastic package body 10.

It can be understood that the above-mentioned multiple embodiments regarding the size of the first substrate 20, the positional relationship between the pad 30 and the first substrate 20 and the plastic package body 10, and the positional relationship between the pads 30 can be used alone as a limitation on the power module, or can be partially or completely combined as a limitation on the power module, as long as the orthographic projection of the pad 30 on the first surface 101 does not overlap with the orthographic projection of the first substrate 20 on the first surface 101.

In the embodiment of the present disclosure, as shown in FIGS. 3 to 12, the power module 100 may further include a second substrate 50 disposed in the plastic package body 10, a driver chip 60 disposed on the second substrate 50, and a plurality of power pins 70 and a plurality of driver pins 80 that are arranged at intervals along the length direction X of the power module 100. The second substrate 50 and the first substrate 20 are arranged at intervals in the width direction Y of the power module 100. An end of the power pin 70 is connected to the first substrate 20, and another end of the power pin 70 extends out of the plastic package body 10; an end of the driver pin 80 is connected to the second substrate 50, and another end of the driver pin 80 extends out of the plastic package body 10. The plurality of driver pins 80 and the plurality of power pins 70 are located on two sides of the power module 100 along the width direction Y thereof.

The driver chip 60 is electrically connected to the power chip 40 and is used to drive the power chip 40 to work, so as to realize the function of the power module 100. For example, the driver chip 60 may include a first driver chip such as a low-voltage driver chip and a second driver chip such as a high-voltage driver chip, and a portion of the plurality of driver pins 80 is electrically connected to the low-voltage driver chip, and another portion of the plurality of driver pins 80 is electrically connected to the high-voltage driver chip. When the power module 100 is working, the plurality of driver pins 80 and the plurality of power pins 70 may be connected to an external controller, so as to realize the electrical connection between the internal circuit of the power module 100 and the external circuit.

The first substrate 20, the power chip 40, the second substrate 50 and the driver chip 60 each are disposed in the plastic package body 10. For example, the plastic package body 10 may be a protective shell formed by an encapsulating resin, used for protecting its internal structure, so as to make the assembly of the first substrate 20 and the second substrate 50 reliable, and provide good protection for the driver chip 60 and the power chip 40.

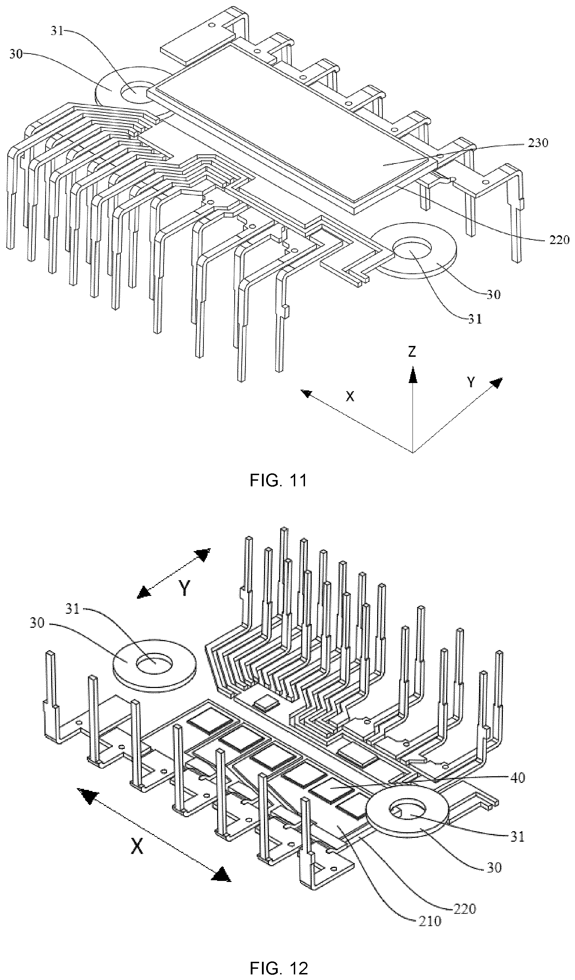

In some embodiments, as shown in FIG. 8, the first substrate 20 may include a conductive layer 210, a ceramic layer 220 and a heat dissipation layer 230. As shown in FIGS. 11 and 12, along the thickness direction Z of the power module 100, the conductive layer 210 and the heat dissipation layer 230 are located on two sides of the ceramic layer 220 respectively, and along the length direction X and the width direction Y of the power module 100, the edge of the ceramic layer 220 protrudes outward relative to the edge of the conductive layer 210. The power chip 40 is disposed on the conductive layer 210, and the surface of the heat dissipation layer 230 away from the conductive layer 210 is flush with a second surface 102 of the plastic package body 10. For example, the conductive layer 210 and the heat dissipation layer 230 each may be a copper layer, and the ceramic layer 220 may be made of an insulating material with good thermal conductivity, and the three together constitute a direct bond copper (DBC) structure. The copper layer on an side of the ceramic layer 220 is etched with a pattern and is configured to carry the power chip 40 and serve as a conductive function, the copper layer on another side of the ceramic layer 220 is an integral layer structure and is configured to provide a heat dissipation path, and the ceramic layer 220 may act as an insulating function.

It can be understood that, for the first substrate 20 of the DBC structure, the above L2 refers to the distance between the center of the pad 30 and the side of the ceramic layer 220 close to the pad 30.

Based on this, when the power module 100 is connected to the heat exchanger, the force transmitted from the pad 30 to the first substrate 20 will first be transmitted to the ceramic layer 220, and then transmitted to the conductive layer 210 and the power chip 40, in this way, the structural reliability of the conductive layer 210 and the power chip 40 located on the conductive layer 210 may be improved. In addition, the heat generated by the power chip 40 during operation may be dissipated promptly through the conductive layer 210 , the ceramic layer 220 and the heat dissipation layer 230, so as to achieve heat dissipation of the power module 100, thereby ensuring the reliability of the power chip 40 and improving the performance of the power module 100.

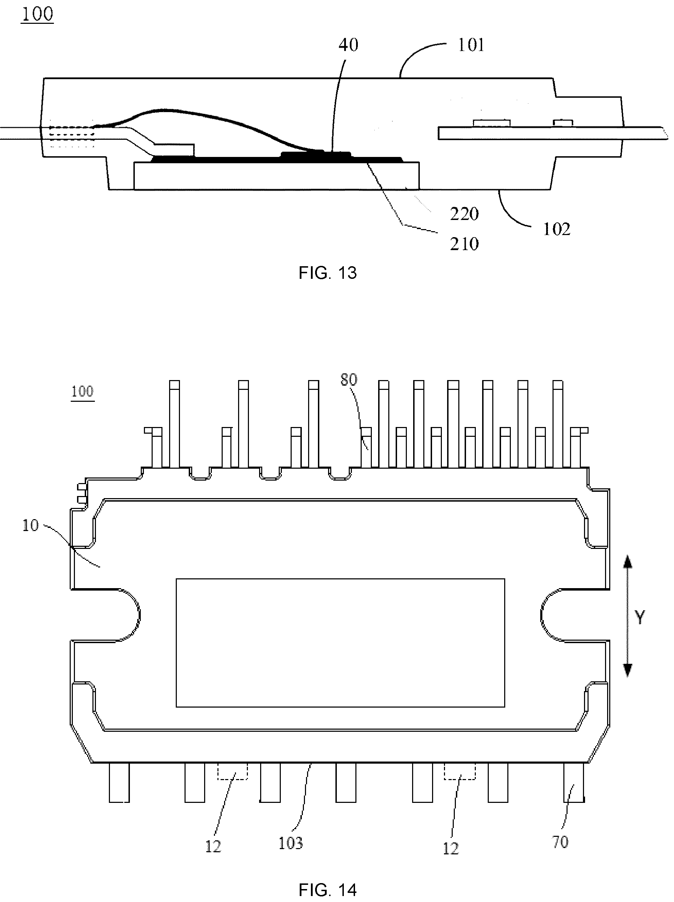

In some other embodiments, as shown in FIG. 13, the first substrate 20 may include the conductive layer 210 and the ceramic layer 220 located on a side of the conductive layer 210 away from the first surface 101. The power chip 40 is disposed on the conductive layer 210, and a surface of the ceramic layer 220 away from the conductive layer 210 is flush with the second surface 102 of the plastic package body 10. For example, the conductive layer 210 may be made of copper, and the ceramic layer 220 may be made of an insulating material with good heat dissipation, and the two may constitute a single-sided copper-clad ceramic plate structure. The copper layer may be etched with a pattern and configured to carry the power chip 40. The surface of the ceramic layer 220 away from the conductive layer 210 is exposed from the plastic package body 10, providing both insulation and heat dissipation effects.

In this way, the heat generated by the power chip 40 during operation may be dissipated promptly through the conductive layer 210 and the ceramic layer 220, so as to achieve heat dissipation of the power module 100, thereby ensuring the reliability of the power chip 40 and improving the performance of the power module 100.

In some other embodiments, the conductive layer 210 may form a one-piece structure with the power pin. That is, the conductive layer 210 includes a portion located in the plastic package body 10 and a portion extending out of the plastic package body 10. The portion of the conductive layer 210 located in the plastic package body 10 may be used as a pad of the power chip 40, and the portion of the conductive layer 210 extending out of the plastic package body 10 may be used as a power pin. On this basis, in addition to the conductive layer 210 having a one-piece structure with the power pin, the first substrate 20 may further include an insulating resin heat sink, which is formed by connecting a heat sink to an side of an insulating resin sink. Another side of the insulating resin sink is connected to the conductive layer 210 constituting the pad of the power chip 40. A surface of the heat sink away from the conductive layer 210 is flush with the second surface 102 of the plastic package body 10. The heat sink may be a copper sheet, and the insulating resin heat sink is usually an insulating resin copper sheet.

It will be noted that the materials of the various layers and the effects that can be realized in this embodiment are similar to those in the above-mentioned embodiment in which the first substrate 20 adopts a DBC structure, which will not be repeated herein.

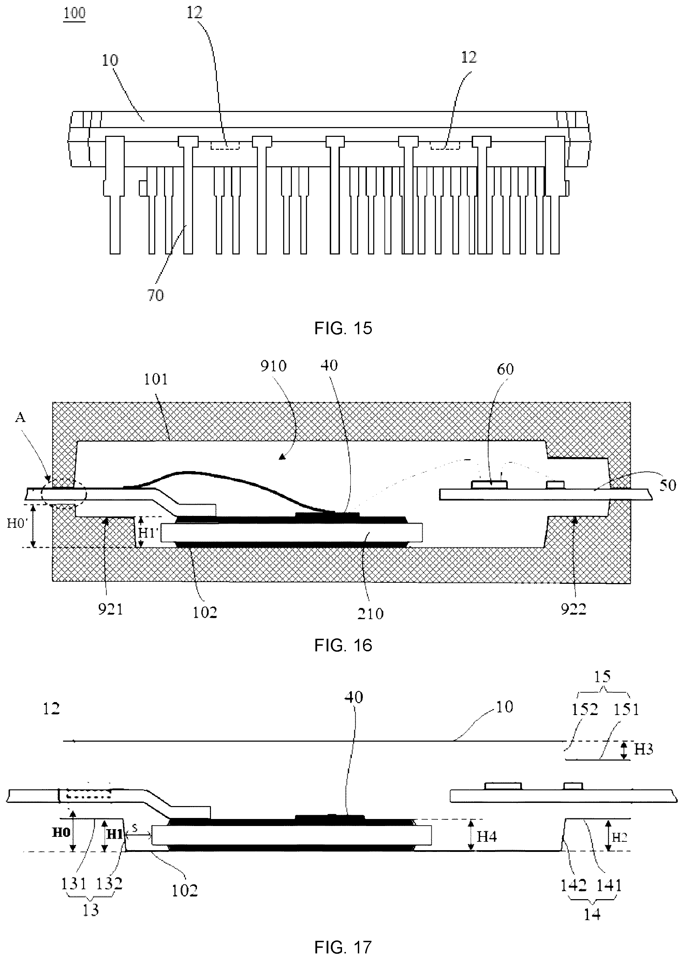

In some embodiments, as shown in FIGS. 14 and 15, the plastic package body 10 may further include at least one resin injection portion 12 located on a first side surface 103 (i.e., the side close to the portion of the power pin 70 extending out of the plastic package body 10) thereof, and the at least one resin injection portion 12 is opposite to the second substrate 50 along the width direction Y of the power module 100.

In the process of encapsulating the main structure of the power module 100 (i.e., the first substrate 20 and the power chip 40, the second substrate 50 and the driver chip 60), as shown in FIG. 16, the main structure of the power module 100 may be disposed in a cavity 910 of the encapsulation mold. The encapsulation mold has a resin injection port A, liquid resin is injected into the cavity 910 through the resin injection port A and filled between the main structure of the power module 100 and the cavity wall of the cavity. After curing, the resin may form the plastic package body 10 in FIG. 17, and the portion of the plastic package body 10 corresponding to the resin injection port A is the resin injection portion 12, and the roughness of the resin injection portion 12 is greater than that of other portions of the plastic package body 10.

The encapsulation mold has an upper shell and a lower shell, the upper shell and the lower shell are buckled together to form an internal cavity, and the side surface of the plastic package body 10 formed by the encapsulation mold has a resin parting surface corresponding to the buckling position of the upper shell and the lower shell. As shown in FIGS. 16 and 17, the resin injection port A is usually disposed near the buckling position of the upper shell and the lower shell. Correspondingly, the resin injection portion 12 is located near the resin parting surface, for example, the resin injection portion 12 is located corresponding to the resin parting surface, or located above or below the resin parting surface. Such provision is conducive to the processing of the encapsulation mold.

Based on this, it can be known that the resin injection portion 12 is disposed on the first side surface 103 of the plastic package body 10 at a position opposite to the second substrate 50. Since the second substrate 50 is provided with the structure of the driver chip 60, these structures will inevitably cause certain resistance to the flow of the resin. The resin injection portion 12 (resin injection port A) is disposed opposite to the second substrate 50, which may enhance the fluidity of the resin and avoid uneven flow rate of the resin.

It can be understood that the second substrate 50 and the first substrate 20 are disposed at intervals in the width direction Y of the power module 100, so that at least one resin injection portion 12 is also disposed opposite to the first substrate 20 along the width direction Y of the power module 100. Similarly, structures such as the power chip 40 on the first substrate 20 will also cause certain resistance to the flow of the resin. The resin injection portion 12 (resin injection port A) is disposed opposite to the first substrate 20, which may also enhance the fluidity of the resin and avoid uneven flow rate of the resin.

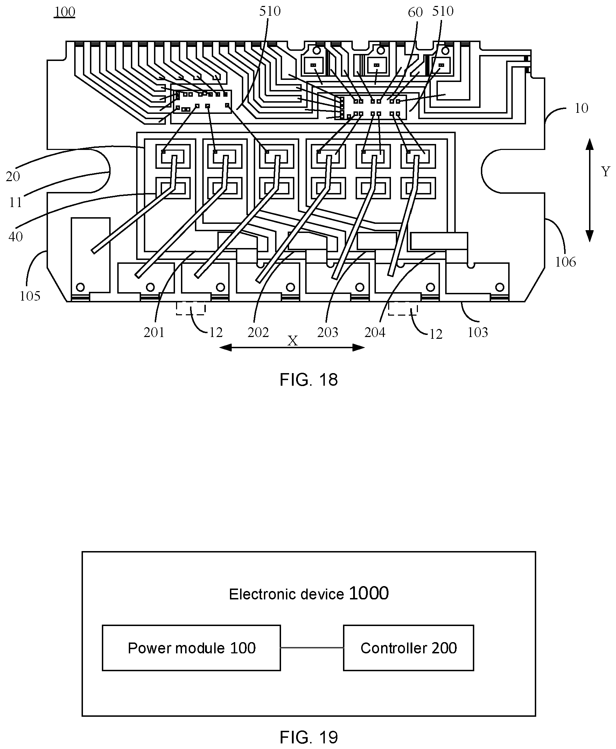

In some embodiments, as shown in FIG. 18, the second substrate 50 may include two soldering portions 510 that are disposed at an interval along the length direction X of the power module 100, each soldering portion 510 is configured to be provided with a driver chip 60, for example, one soldering portion 510 is configured to be provided with a low-voltage driver chip, and another soldering portion 510 is configured to be provided with a high-voltage driver chip. On this basis, the at least one resin injection portion 12 may include two resin injection portions 12. Along the width direction Y of the power module 100, the two resin injection portions 12 correspond to the two soldering portions 510 respectively.

Since the driver chip 60 needs to be electrically connected to the power chip 40 and the driver pins 80 through wires, there are many wires above the soldering portion 510, which will cause a certain resistance to the flow of the resin. During the encapsulation process of the power module 100, the liquid resin flows from the side where the power pin is located to the side where the driver pin is located. As a result, along the width direction Y of the power module 100, resistance of the area corresponding to the soldering portion 510 is greater than that of other areas without soldering portion. The number of resin injection portions 12 is provided to be corresponding to that of soldering portions 510, and the two resin injection portions 12 correspond to the two soldering portions 510 along the width direction Y of the power module 100 (that is, the position of the resin injection port A corresponds to the position of the soldering portion 510), not only the resin fluidity in the area corresponding to the soldering portion 510 may be increased, but also uneven distribution of the resin may be avoided, thereby maintaining the uniformity of the resin flow in the cavity and avoiding the generation of gaps.

In some embodiments, as shown in FIG. 18, the two soldering portions 510 may include a first soldering portion 510 close to a third side surface 105 of the plastic package body 10 and a second soldering portion 510 close to a fourth side surface 106 of the plastic package body 10, the third side surface 105 and the fourth side surface 106 are opposite to each other along the length direction X of the power module 100. Along the width direction Y of the power module 100, one of the two resin injection portions 12 corresponds to a portion of the first soldering portion 510 close to the third side surface 105, and another resin injection portion 12 corresponds to a portion of the second soldering portion 510 close to the fourth side surface 106. That is, along the length direction X of the power module 100, the distance from the resin injection portion 12 (i.e., resin injection port A) to the edge of the corresponding soldering portion 510 away from the plastic package body 10 is greater than the distance from the resin injection portion 12 (i.e., resin injection port A) to the edge of the corresponding soldering portion 510 close to the plastic package body 10.

It will be noted that, in the length direction X of the power module 100, the portion of the first soldering portion 510 close to the third side surface 105 is located in the middle of the left half of the plastic package body 10, and the portion of the second soldering portion 510 close to the fourth side surface 106 is located in the middle of the right half of the plastic package body 10.

In this way, the two resin injection portions 12 (i.e., resin injection ports A) may be respectively disposed in the middle of the two parts of the plastic package body 10 along the length direction X of the power module 100, which is conducive to maintaining the uniformity of the resin flow in the cavity and thus avoiding the generation of gaps.

On this basis, as shown in FIG. 18, a first driver chip, such as a low-voltage driver chip, may be disposed on the first soldering portion 510, and a second driver chip, such as a high-voltage driver chip, may be disposed on the second soldering portion 510. Along the width direction Y of the power module 100, the distance from the first driver chip to the edge of the first soldering portion 510 close to the driver pin 80 is less than the distance from the first driver chip to the edge of the first soldering portion 510 close to the power pin 70, and the distance from the second driver chip to the edge of the second soldering portion 510 close to the driver pin 80 is substantially equal to the distance from the second driver chip to the edge of the second soldering portion 510 close to the power pin 70.

That is to say, the first driver chip is disposed on the first soldering portion 510 close to the side where the driver pin 80 is located, and the second driver chip is disposed on the middle of the second soldering portion 510.

Since a low-voltage driver chip is disposed on the first soldering portion 510, and the driver pins electrically connected to the low-voltage driver chip are densely arranged, the low-voltage driver chip is disposed on the side of the first soldering portion 510 close to the driver pin 80, which can reduce the deformation of the wire used to electrically connect the low-voltage driver chip and the corresponding driver pin, so as to optimize the structural design of the power module 100.

A dimension of the second soldering portion 510 along the length direction X of the power module 100 is greater than that of the first soldering portion 510 along the length direction X of the power module 100. Since a high-voltage driver chip is provided on the second soldering portion 510, compared with the low-voltage driver chip, the amount of driver pins used to electrically connected to the high-voltage driver chip is less. Therefore, providing the high-voltage driver chip at the middle position on the second soldering portion 510 is conducive to ensuring the stability and reliability of the high-voltage driver chip.

In some embodiments, as shown in FIG. 18, the first substrate 20 may include a first base island 201, a second base island 202, a third base island 203 and a fourth base island 204 that are disposed at intervals in sequence along the length direction X of the power module 100, and at least one power chip 40 is provided on each base island.

In this case, along the width direction Y of the power module 100, the two resin injection portions 12 may correspond to the first base island 201 and the fourth base island 204 respectively. Such provision is conducive to maintaining the uniformity of the resin flow in the cavity, thus avoiding the generation of gaps.

Alternatively, along the width direction Y of the power module 100, one resin injection portion 12 may correspond to a position between the first base island 201 and the second base island 202, and another resin injection portion 12 may correspond to the fourth base island 204. Such provision is conducive to improving the uniformity of the resin flowing between the first base island 201 and the second base island 202, thus further preventing the generation of gaps.

As shown in FIG. 18, the plurality of power pins 70 of the power module 100 include a first power pin electrically connected to the power chip 40 on the first base island 201, a second power pin electrically connected to the power chip 40 on the second base island 202, a third power pin electrically connected to the power chip 40 on the third base island 203, and a fourth power pin (i.e., a plurality of fourth power pins) electrically connected to the power chip 40 on the fourth base island 204. The power chip 40 is electrically connected to the corresponding power pins through wires.

It can be understood that, based on the structural design of each base island, each base island and its corresponding power pin are not directly opposite in the width direction Y of the power module 100. For example, the first base island 201 may correspond to the third power pin in the width direction Y of the power module 100, and the second base island 202, the third base island 203 and the fourth base island 204 each may correspond to one or more of the plurality of fourth power pins in the width direction Y of the power module 100.

Based on this, along the width direction Y of the power module 100, one resin injection portion 12 may correspond to the third power pin, and another resin injection portion 12 may correspond to the fourth power pin farthest from the third power pin among the plurality of fourth power pins. In this case, the third power pin and the fourth power pin corresponding to the resin injection portion 12 are respectively located in the middle of the two parts of the plastic package body 10 along the length direction X of the power module 100, which is conducive to maintaining the uniformity of the resin flow in the cavity, thus avoiding the generation of gaps.

For example, at least one of the first power pin, the second power pin, the third power pin and the fourth power pin is provided with a through hole, which can increase the adhesion between the resin and the encapsulation mold and prevent external moisture or air from entering the cavity of the encapsulation mold, thereby further avoiding the generation of gaps and improving the reliability of the power module 100.

Considering that the power module 100 is a structure obtained by using a liquid resin to encapsulate a main structure disposed in a cavity of an encapsulation mold and allowing the resin to cure, the flowing resin is prone to impact the first substrate 20, causing the first substrate 20 to displace, therefore, in some embodiments, as shown in FIGS. 3 and 17, the plastic package body 10 may further include a first step portion 13 recessed in the direction of the plurality of power pins 70 pointing to the plurality of driver pins 80, and the first step portion 13 is located on the portion of the plurality of power pins 70 extend out of the plastic package body 10, and close to the side of the second surface 102 of the plastic package body 10. The first step portion 13 has a first step surface 131 and a first connection surface 132 connected between the first step surface 131 and the second surface 102. In the case where the first substrate 20 adopts a DBC structure or a single-sided copper-clad ceramic plate structure, along the thickness direction Z of the power module 100, the distance H1 from the first step surface 131 to the second surface 102 is less than the distance H0 from the resin injection portion 12 to the second surface 102, and the distance H1 from the first step surface 131 to the second surface 102 is less than the distance H4 from the surface of the power chip 40 away from the second surface 102 to the second surface 102. Here, the recessed first step portion 13 refers to the first step portion 13 being recessed toward the interior of the plastic package body 10.

It can be understood that, the shape of the cavity wall of the encapsulation mold matches the outer shape of the plastic package body 10. It can be seen that, as shown in FIG. 16, the cavity 910 of the encapsulation mold has a first step 921 corresponding to the first step portion 13 of the plastic package body 10, and the distance H1' from the step surface of the first step 921 to the bottom surface of the cavity is less than the distance from the surface of the power chip 40 away from the bottom surface of the cavity to the bottom surface of the cavity, and the distance H1' from the step surface of the first step 921 to the bottom surface of the cavity is less than the height of the resin injection port A (i.e., the distance from the resin injection port A to the bottom surface of the cavity) H0'.

In this case, the provision of the first step portion 13 may reduce the space between the first substrate 20 and the side of the cavity of the encapsulation mold corresponding to the side where the power pin 70 is located, so as to reduce the amount of resin accumulated at this position during the resin injection process, and reduce the risk of burrs caused by resin overflow from the bottom surface of the first substrate 20. In addition, since the distance H1 from the first step surface 131 to the second surface 102 is less than the distance H0 from the resin injection portion 12 to the second surface 102, when the resin is injected into the cavity of the encapsulation mold through the resin injection port A, the liquid resin first falls on the first step 921. The first step provides a certain buffering effect on the liquid resin, reduces the height from which the resin flows toward the first substrate 20 and decreases the oblique downward impact force of the resin on the first substrate 20. On this basis, the distance H1 from the first step surface 131 to the second surface 102 is less than the distance H4 from the top surface of the power chip 40 to the second surface 102, so that the resin is made to flow from low to high towards the power chip 40, as a result, the flow of the resin is smooth, further reducing the impact force of the resin on the first substrate 20 and the power chip 40, thereby alleviating the problem of possible displacement of the first substrate 20.

In some embodiments, the distance H1 from the first step surface 131 to the second surface 102 may be less than the distance from the surface of the power chip 40 close to the first surface 101 to the second surface 102 (i.e., a height of the power chip 40). In this way, when the resin is injected into the cavity of the encapsulation mold through the resin injection port A, the resin may flow relatively smoothly to the first substrate 20 and the power chip 40, which reduced the impact force of the resin on the first substrate 20 and the power chip 40, thereby further alleviating the problem of possible displacement of the first substrate 20.

In some embodiments, the distance H0 from the resin injection portion 12 to the second surface 102 may be greater than the distance from the surface of the power chip 40 close to the first surface 101 to the second surface 102 (i.e., the height of the power chip 40). In this way, when the resin is injected into the cavity of the encapsulation mold through the resin injection port A, the injected resin may submerge the power chip 40, so as to encapsulate the power chip 40 in the plastic package body 10.

Furthermore, a distance S from the edge of the first substrate 20 close to the first side surface 103 of the plastic package body 10 to the first connection surface 132 is greater than 0.5 times the thickness of the first substrate 20 and less than 1.5 times the thickness of the first substrate 20 (i.e., S satisfies: 0.5 times the thickness of the first substrate 20<S<1.5 times the thickness of the first substrate 20).

If S is too large, it is easy to cause the resin to overflow from the bottom surface of the first substrate 20. For example, in a case where S is greater than or equal to 1.5 times the thickness of the first substrate 20(i.e., S≥1.5 times the thickness of the first substrate 20), the space between the edge of the first substrate 20 close to the power pin 70 and the first connection surface 132 is large, and resin is easily accumulated at the position, resulting in the defect that the resin may overflow from the bottom surface of the first substrate 20 and cause burrs.

If S is too small, it will be difficult for the resin to fill the space between the first connection surface 132 and the first side surface 103 of the plastic package body 10, which may easily lead to the generation of gaps. For example, in a case where S is less than or equal to 0.5 times the thickness of the first substrate 20, an elongated narrow gap may be formed between the edge of the first substrate 20 close to the power pin 70 and the first connection surface 132, resulting in difficulty for the resin to fill the position and thus easily causing the defect of the gap.

For example, the thickness of the first substrate 20 is1.05 mm. If S is equal to 0.518mm (i.e., S=0.518mm), it is difficult for the resin to fill the space; if S is equal to 2.0mm(i.e., S=2.0mm), the first substrate 20 is prone to overflow risks.

Based on this, by limiting the distance S to between 0.5 times and 1.5 times the thickness of the first substrate 20, it is easy to fill the space with resin, and the risk of resin accumulation causing overflow from the bottom surface of the first substrate 20 may be reduced, so as to prevent burrs and avoid gaps, ensure the insulation stability of the power module 100 and improve its electrical safety.

In some embodiments, as shown in FIGS. 3 and 17, the plastic package body 10 may further include a second step portion 14 recessed in the direction of the plurality of driver pins 80 pointing to the plurality of power pins 70, and the second step portion 14 is located on the portion of the plurality of driver pins 80 extend out of the plastic package body 10, and close to the side of the second surface 102 of the plastic package body 10. The second step portion 14 has a second step surface 141 and a second connection surface 142 connected between the second step surface 141 and the second surface 102. Along the thickness direction Z of the power module 100, a distance H2 from the second step surface 141 to the second surface 102 is substantially equal to the distance H1 from the first step surface 131 to the second surface 102. And/or, along the width direction Y of the power module 100, the distance from the second connection surface 142 to the second side surface 104 of the plastic package body 10 opposite to the first side surface 103 is substantially equal to the distance from the first connection surface 132 to the first side surface 103. Here, the recessed second step portion 14 refers to the second step portion 14 being recessed toward the interior of the plastic package body 10.

Similar to the first step portion 13, as shown in FIGS. 16 and 18, the cavity 910 of the encapsulation mold has a second step 922 corresponding to the second step portion 14 of the plastic package body 10, and the structural dimensions of the second step 922 may refer to the above description of the second step portion 14.

In this case, the provision of the second step portion 14 may reduce the space between the first substrate 20 and the surface of the cavity of the encapsulation mold corresponding to the side where the driver pin 80 is located, so as to reduce the amount of resin accumulated at this position during the resin injection process, and reduce the risk of burrs caused by resin overflow from the bottom surface of the first substrate 20. The provision of the second step portion 14 may also regulates the flow rate of the resin in the area close to the driver pin 80 in the cavity, so that the overall mold flow speed is balanced, thereby speeding up the injection time and avoiding the generation of gaps. In addition, the second step portion 14 and the first step portion 13 are symmetrically arranged along the width direction Y of the power module 100, which may simplify the production process.

In some embodiments, as shown in FIGS. 4 and 17, the plastic package body 10 may further include a third step portion 15 recessed in the direction of the plurality of power pins 70 pointing to the plurality of driver pins 80, and the third step portion 15 is located on the portion of the plurality of driver pins 80 extend out of the plastic package body 10, and close to the side of the first surface 101 of the plastic package body 10. The third step portion 15 has a third step surface 151 and a third connection surface 152 connected between the third step surface 151 and the first surface 101. Along the thickness direction Z of the power module 100, a distance H3 from the third step surface 151 to the first surface 101 is less than the distance H1 from the first step surface 131 to the second surface 102.

In this case, by providing steps on both the upper and lower surfaces of the side of the plastic package body 10 where the driver pin 80 is provided, the flow rate of the resin in the area close to the driver pin 80 in the cavity may be better adjusted, so that the speed of the entire mold flow is more balanced, thereby speeding up the injection time and avoiding the generation of gaps.

In some embodiments, as shown in FIGS. 3 and 4, at least one of the first step portion 13, the second step portion 14, and the third step portion 15 may include a flow guide portion. The flow guide portion may be disposed at the corner of the corresponding step portion, so as to generate a component force to guide the resin to the opposite side when the resin flows, promote the flow of the resin at the corner position, thereby avoiding the risk of gaps caused by stagnation and accumulation of resin at the corner.

It can be understood that, the corner of the step portion refers to a portion of the connection surface of the step portion located between the main body portion extending along the length direction X of the power module 100 and the end portion extending along the width direction Y of the power module 100. For example, the flow guide portion may be a chamfer, a rounded corner, a groove, or other structures that may realize the resin guide function.

In some examples, the first step portion 13 may include a first flow guide portion 133 located at at least one corner. The first step portion 13 may include a first main body portion extending along the length direction X of the power module 100, a first end portion extending along the width direction Y of the power module 100, and the first flow guide portion 133 connected between the first main body portion and the first end portion.

In another examples, the second step portion 14 may include a second flow guide portion 143 located at at least one corner.

In yet another examples, the third step portion 15 may include a third flow guide portion 153 located at at least one corner.

The structures of the second flow guide portion 143 and the third flow guide portion 153 are similar to the structure of the first flow guide portion 133, which will not be repeated herein.

It should be noted that, except that the flow guide portion may be formed at the corner position of at least one of the first step portion 13, the second step portion 14 and the third step portion 15, a flow guide portion may also be formed at a corner position between any two adjacent side surfaces of the first side surface 103, the second side surface 104, the third side surface 105 and the fourth side surface 106 of the plastic package body 10, for example, a flow guide portion may be formed at each corner, or a flow guide portion may be selectively formed at certain corners.

In this case, when the liquid resin flows to the corner in the cavity corresponding to the flow guide portion, the flow guide portion may promote the flow of the resin, so as to prevent the resin from stagnating and accumulating to form resin gaps. In addition, the provision of the flow guide portion may also reduce the amount of resin accumulation, thereby further reducing the risk of burrs caused by resin overflow from the bottom surface of the first substrate 20.

Embodiments of the present disclosure provide an electronic device. As shown in FIG. 19, the electronic device 1000 may include a power module 100 in any of the above embodiments and a controller 200 connected to the power module 100.

For example, the power module 100 may be one or more, and the electronic device 1000 may include but is not limited to an inverter device or a rectifier device, for example, the electronic device 1000 may be a motor drive controller. The controller 200 may generate a control signal according to a user instruction and send the control signal to the power module 100. The power module 100 may generate a drive signal according to the control signal and output the drive signal to the corresponding driven component to realize functions such as drive control, inversion, rectification conversion or the like.

Based on this, by applying the power module 100 in the above embodiments to the electronic device, the structural stability and electrical safety of the electronic device may be improved, thereby enhancing the product competitiveness of the electronic device and improving the user experience.

It should be noted that the electronic device provided in the embodiments of the present disclosure have the same technical effect as the power module in the above-mentioned embodiments included therein, which will not be described in detail herein.

In the description of the present disclosure, a first feature being "on" or "under" the second feature may include the first and second features are directly in contact with each other, or may include that the first and second features are not in direct contact with each other but being in contact with each other via another feature therebetween. The phrase "on", "over", and "above" the first feature includes the first feature being directly above and obliquely above the second feature, or simply indicating that the first feature is horizontally higher than the second feature.

In the description of the present disclosure, it will be understood that, orientations or positional relationships indicated by the terms such as "center", "longitudinal", "transverse", "length", "width", "thickness", "top", "bottom", "front", "back", "left", "right", "vertical", "horizontal", "inner", "outer" ,"clockwise", "counterclockwise", "axial", "radial", "circumferential" are based on orientations or positional relationships shown in the drawings, which is merely for convenience in description of the present disclosure and simplifying the description, but not to indicate or imply that the indicated apparatus or element must have a specific orientation, or be constructed and operated in a specific orientation.

Although the embodiments of the present disclosure have shown and described, a person skilled in the art will understand that: various changes, modifications, substitutions and variations may be made to the embodiments without departing from the principles and spirit of the invention, and the scope of the invention is limited by the claims and their equivalents.

A person skilled in the art will understand that the scope of disclosure in the present disclosure is not limited to the specific embodiments described above, and may modify and substitute some elements of the embodiments without departing from the concept of the present disclosure. The scope of the present disclosure is limited by the appended claims.

## Claims

1. A power module assembly, comprising:
a plastic package body having a first surface and a second surface that are opposite to each other and including at least one connection portion located at an end of the plastic package body;
a first substrate disposed in the plastic package body;
a power chip disposed on the first substrate; and
at least one pad disposed on the first surface of the plastic package body and corresponding to the at least one connection portion, and an orthographic projection of the pad on the first surface does not overlap with an orthographic projection of the first substrate on the first surface;
wherein the plastic package body is configured to be connected to a heat exchanger by means of the pad and the connection portion, so that the second surface of the plastic package body is in contact with the heat exchanger.

2. The power module assembly according to claim 1, wherein the orthographic projection of the pad on the first surface and the orthographic projection of the first substrate on the first surface are disposed at an interval.

3. The power module assembly according to claim 1 or 2, wherein the at least one connection portion includes two connection portions located at two ends of the plastic package body along a length direction of the plastic package body and symmetrically arranged, and the at least one pad includes two pads corresponding to the two connection portions respectively.

4. The power module assembly according to claim 3, wherein the connection portion includes a notch; and along a thickness direction of the plastic package body, a center of the pad is directly opposite to a center of the notch.

5. The power module assembly according to claim 4, wherein a distance between centers of the two pads is L3, and L3 is greater than 29.5mm and less than 30mm.

6. The power module assembly according to any one of claims 1 to 5, wherein a dimension of the first substrate along a length direction of the plastic package body is L1, and L1 is greater than 22.3mm and less than 22.9mm; and/or
a distance between a center of the pad and a side of the first substrate close to the pad is L2, and L2 is greater than 3.45mm and less than 3.75mm; and/or
a distance between the center of the pad and a side of the plastic package body close to the pad is L4, and L4 is greater than 1.5mm and less than or equal to 3mm.

7. The power module assembly according to any one of claims 1 to 6, wherein the pad is a circular pad, a diameter of the pad is D, and D is greater than 6.8mm and less than 7mm.

8. The power module assembly according to any one of claims 1 to 7, wherein the first substrate includes a conductive layer, a ceramic layer and a heat dissipation layer; along a thickness direction of the plastic package body, the conductive layer and the heat dissipation layer are located on two sides of the ceramic layer respectively; the power chip is disposed on the conductive layer, and a surface of the heat dissipation layer away from the conductive layer is flush with the second surface of the plastic package body; or
the first substrate includes the conductive layer and the ceramic layer located on a side of the conductive layer away from the first surface; the power chip is disposed on the conductive layer, and a surface of the ceramic layer away from the conductive layer is flush with the second surface of the plastic package body.

9. The power module assembly according to any one of claims 1 to 8, further comprising:
a second substrate disposed in the plastic package body; the second substrate and the first substrate being disposed at an interval in a width direction of the plastic package body;
a driver chip disposed on the second substrate; the driver chip being electrically connected to the power chip;
a plurality of driver pins disposed at intervals along a length direction of the plastic package body; an end of the driver pin being connected to the second substrate, and another end of the driver pin extending out of the plastic package body;
a plurality of power pins disposed at intervals along the length direction of the plastic package body; an end of the power pin being connected to the first substrate, and another end of the power pin extending out of the plastic package body; and
at least one resin injection portion located on a first side surface of the plastic package body close to a portion of the power pin extending out of the plastic package body;
wherein the plurality of driver pins and the plurality of power pins are located on two sides of the plastic package body along the width direction thereof.

10. The power module assembly according to claim 9, wherein the second substrate includes two soldering portions disposed at the length direction of the plastic package body, and the soldering portions each are configured to be provided with a driver chip;
the at least one resin injection portion includes two resin injection portions; along the width direction of the plastic package body, the two resin injection portions correspond to the two soldering portions respectively.

11. The power module assembly according to claim 10, wherein the two soldering portions includes a first soldering portion close to a third side surface of the plastic package body and a second soldering portion close to a fourth side surface of the plastic package body, and the third side surface and the fourth side surface are opposite to each other along the length direction of the plastic package body;
one of the two resin injection portions corresponds to a portion of the first soldering portion close to the third side surface, and another resin injection portion corresponds to a portion of the second soldering portion close to the fourth side surface.

12. The power module assembly according to claim 10 or 11, wherein the first substrate includes a first base island, a second base island, a third base island and a fourth base island that are disposed at an interval in sequence along the length direction of the plastic package body;
along the width direction of the plastic package body, the two resin injection portions correspond to the first base island and the fourth base island respectively.

13. The power module assembly according to claim 10, wherein the two soldering portions includes a first soldering portion close to a third side surface of the plastic package body and a second soldering portion close to a fourth side surface of the plastic package body, and the third side surface and the fourth side surface are opposite to each other along the length direction of the plastic package body;
the driver chip includes a first driver chip and a second driver chip, the first driver chip being disposed on the first soldering portion, and the second driver chip being disposed on the second soldering portion;
wherein along the width direction of the plastic package body, a distance between the first driver chip and an edge of the first soldering portion close to the driver pin is less than a distance between the first driver chip and an edge of the first soldering portion close to the power pin.

14. The power module assembly according to claim 13, wherein along the width direction of the plastic package body, a distance from the second driver chip to an edge of the second soldering portion close to the driver pin is substantially equal to a distance from the second driver chip to an edge of the second soldering portion close to the power pin.

15. The power module assembly according to any one of claims 9 to 14, wherein the plastic package body further includes:
a first step portion located on a portion of the plurality of power pins extend out of the plastic package body, and close to a side of the second surface of the plastic package body, and recessed in a direction of the plurality of power pins pointing to the plurality of driver pins; wherein the first step portion has a first step surface and a first connection surface connected between the first step surface and the second surface;
wherein along a thickness direction of the plastic package body, a distance from the first step surface to the second surface is less than a distance from a surface of the power chip away from the second surface to the second surface.

16. The power module assembly according to claim 15, wherein a distance S from an edge of the first substrate close to the first side surface of the plastic package body to the first connection surface satisfies following: S is greater than 0.5 times a thickness of the first substrate and less than 1.5 times the thickness of the first substrate.

17. The power module assembly according to claim 15 or 16, wherein the plastic package body further includes:
a second step portion located on a portion of the plurality of driver pins extend out of the plastic package body, and close to a side of the second surface of the plastic package body, and recessed in a direction of the plurality of driver pins pointing to the plurality of power pins; wherein the second step portion has a second step surface and a second connection surface connected between the second step surface and the second surface;
wherein along the thickness direction of the plastic package body, a distance from the second step surface to the second surface is substantially equal to the distance from the first step surface to the second surface; and/or, along the width direction of the plastic package body, a distance from the second connection surface to a second side surface of the plastic package body opposite to the first side surface is substantially equal to a distance from the first connection surface to the first side surface.

18. The power module assembly according to any one of claims 15 to 17, wherein the plastic package body further includes:
a third step portion located on a portion of the plurality of driver pins extend out of the plastic package body, and close to a side of the first surface of the plastic package body, and recessed in a direction in which the plurality of driver pins pointing to the plurality of power pins; wherein the third step portion has a third step surface and a third connection surface connected between the third step surface and the first surface;
wherein along the thickness direction of the plastic package body, a distance from the third step surface to the first surface is less than the distance from the first step surface to the second surface.

19. The power module assembly according to claim 18, wherein the first step portion includes a first flow guide portion located at a corner; and/or, the second step portion includes a second flow guide portion located at a corner; and/or, the third step portion includes a third flow guide portion located at a corner.

20. An electronic device comprising a controller and the power module assembly according to any one of claims 1 to 19, wherein the power module assembly is connected to the controller.
